(19) **Europäisches Patentamt**

**European Patent Office**

**Office européen des brevets**

(11) Veröffentlichungsnummer : **0 543 398 B1**

(12) # EUROPÄISCHE PATENTSCHRIFT

(45) Veröffentlichungstag der Patentschrift :
**20.07.94 Patentblatt 94/29**

(51) Int. Cl.⁵ : **C04B 35/58**

(21) Anmeldenummer : **92119804.0**

(22) Anmeldetag : **20.11.92**

(54) **Wiederaufbereitung von gebrauchten Verdampferschiffchen.**

(30) Priorität : **22.11.91 DE 4138481**

(43) Veröffentlichungstag der Anmeldung :
**26.05.93 Patentblatt 93/21**

(45) Bekanntmachung des Hinweises auf die
Patenterteilung :
**20.07.94 Patentblatt 94/29**

(84) Benannte Vertragsstaaten :
**BE CH DE FR GB IT LI**

(56) Entgegenhaltungen :
**EP-A- 0 429 345**
**EP-A- 0 494 129**
**FR-A- 2 170 839**
**GB-A- 2 210 872**

(73) Patentinhaber : **Elektroschmelzwerk Kempten GmbH**
**Hanns-Seidel-Platz 4**
**D-81737 München (DE)**

(72) Erfinder : **Hunold, Klaus, Dr. Dipl.-Ing.**
**Hochgratweg 8**
**W-8961 Lauben (DE)**
Erfinder : **Matje, Peter, Dr. Dipl.-Chem.**
**Schwarzachen 4**
**W-8961 Wiggensbach (DE)**

EP 0 543 398 B1

Jouve, 18, rue Saint-Denis, 75001 PARIS

## Beschreibung

Die Erfindung betrifft die Wiederaufarbeitung von gebrauchten Verdampferschiffchen.

Verdampferschiffchen werden im allgemeinen zum Verdampfen von Metallen wie Aluminium verwendet. Beispiele dafür sind in den folgenden US-Patenten beschrieben:

43 73 952, 40 89 643, 39 15 900, 38 13 252, 38 03 707, 35 82 611, 35 44 486, 32 56 103, 31 81 968, 29 84 807, 29 62 538.

Während des normalen Betriebes der Verdampferschiffchen findet durch die Wechselwirkung mit geschmolzenem Aluminium eine Erosion der Materialkomponenten des Schiffchens statt. Obwohl nur eine geringe Menge der Materialkomponenten erodiert ist, verliert das Schiffchen auf diese Weise seine Betriebsfähigkeit, da der effektive Querschnitt des Schiffchens und der spezifische elektrische Widerstand verändert sind. Das Schiffchen wird in diesem Fall normalerweise ausgesondert und ersetzt, nachdem es in der Regel nur 10 bis 15 % abgenutzt ist.

Ein Verfahren, die gebrauchten Verdampfer wiederaufzubereiten, wird in der DE-OS 38 39 730 (entspricht US 4 847 031) beschrieben. Gemäß den dort beschriebenen Verfahren werden die gebrauchten Schiffchen, die in der Regel mit größeren Mengen Aluminium verunreinigt sind, zunächst mit einer heißen Natronlauge behandelt, um das Aluminium zu entfernen. Anschließend werden die Schiffchen mit Salzsäure neutralisiert, mit Wasser gewaschen, zu Pulver gemahlen und gesiebt. Das gesiebte Pulver wird zur Herstellung neuer Schiffchen verwendet. Dieses Verfahren hat folgende Nachteile:

Die drei Behandlungsschritte zur Reinigung der Verdampferschiffchen von Aluminium-Resten sind sehr aufwendig. Es fallen größere Mengen verunreinigter Laugen und Säuren sowie fester aluminiumhaltiger Abfall an. Dieser Abfall muß kostenaufwendig und umweltbelastend entsorgt werden. Es besteht die Gefahr, daß das nach diesem Verfahren gereinigte Material mit Alkali oder OH-Ionen verunreinigt ist. Letzteres macht sich speziell bei den oxidationsempfindlichen, recht feinen Pulvern dergestalt bemerkbar, daß das recyclete Material höhere Sauerstoffwerte aufweist als das ursprüngliche Verdampfermaterial. Hierdurch erleidet ein Verdampfer aus recycletem Material Qualitätseinbußen.

Aufgabe der Erfindung war es, ein Verfahren zur Verfügung zu stellen, das ein umweltfreundliches, abfallarmes Wiederaufarbeiten gebrauchter Verdampferschiffchen ermöglicht.

Die Aufgabe wird gelöst durch ein Verfahren, das dadurch gekennzeichnet ist, daß gebrauchte, mit Aluminium verunreinigte keramische Verdampferschiffchen zerkleinert und in Stickstoff-haltiger Atmosphäre geglüht werden.

Als Ausgangsmaterial sind alle Arten von gebrauchten keramischen Verdampferschiffchen geeignet. Diese gebrauchten, eigenwiderstandserhitzten, elektrisch leitfähigen, feuerfesten Verdampferschiffchen bestehen in der Regel aus Titanborid, Bornitrid und Aluminiumnitrid oder aus Titanborid und Bornitrid. Zum Teil enthalten sie auch noch geringe Mengen anderer Boride, Nitride, Carbide, Oxide und/oder Kohlenstoff. Die gebrauchten Verdampferschiffchen werden mit geeigneten Aggregaten wie beispielsweise Kugelmühlen, Backenbrechern und/oder Strahlmühlen auf Korngrößen unter 1 mm, bevorzugt unter 100 $\mu$m, zerkleinert. Das so erhaltene Pulver wird bei Temperaturen von 400°C bis 1600°C, bevorzugt von 400°C bis 1000°C, in stickstoffhaltiger Atmosphäre wie z. B. $N_2$- und/oder $NH_3$-haltiger Atmosphäre, bei einem Partialdruck der stickstoffhaltigen Komponente von 0,01-10 MPa (0,1 bis 100 bar) bis zu 100 Stunden, bevorzugt 10 bis 24 Stunden, geglüht. Beim Glühen wird das freie Aluminium zu Aluminiumnitrid umgesetzt. Dem gemahlenen Pulver kann Kohlenstoff in feinstverteilter Form, beispielsweise als Ruß in Mengen bis zu 10 Gew.%, bevorzugt bis zu 1 Gew.%, zugesetzt werden. Dadurch wird die Nitridierung des in dem Pulver vorhandenen Aluminiumoxids erreicht. Das Nitridieren kann beispielsweise je nach verwendetem Ofentyp unterschiedlich erfolgen. Während z.B. ein Vakuumofen nur chargenweises Nitridieren ermöglicht, erlaubt z. B. ein Wirbelschichtofen ein kontinuierliches Nitridieren.

Nach den genannten Glühzeiten liegt der Anteil an unreagiertem metallischem Aluminium in der Regel bei weniger als 0,1 Gew.-%. In Mengen unter 0,5 Gew.% ist metallisches Aluminium bei der Herstellung neuer Verdampferschiffchen nicht störend. Mehr als 0,5 Gew.% metallisches Aluminium führt bei der Herstellung neuer Verdampferschiffchen zu einer kontinuierlichen Verschlechterung der Verdampfereigenschaften. Ein Aluminiumgehalt von mehr als 1 Gew.% bewirkt deutliche Einbußen im Eigenschaftsprofil der Verdampferschiffchen.

Verdampferschiffchen lassen sich nach bekannten Verfahren wie beispielsweise Heißpressen oder Heißisostatpressen aus den erhaltenen Pulvern herstellen.

Das erfindungsgemäße Verfahren hat gegenüber dem bekannten Verfahren folgende Vorteile:

Bei dem erfindungsgemäßen Wiederaufarbeitsverfahren fallen weder flüssiger noch fester Abfall an. Der bisher entsorgte anhaftende aluminiumhaltige Abfall wird als Rohstoff wiederverwertet.

Durch die Temperaturbehandlung in stickstoffhaltiger Atmosphäre werden Aluminium bzw. aluminiumhaltige Verbindungen zu Aluminiumnitrid, einem typischen Verdampferrohstoff, umgesetzt.

Ein Einschleppen von Verunreinigungen und daraus resultierende Qualitätseinbußen bei der Wiederaufarbeitung ist ausgeschlossen.

Das erfindungsgemäße Verfahren ist sehr wirtschaftlich.

Durch das erfindungsgemäße Verfahren der Wiederaufarbeitung ist der AlN-Gehalt der Pulvermischung im Vergleich zu dem der Ausgangsmischung erhöht. Um auf die Ausgangsmischung der eingesetzten Verdampferschiffchen oder die für das jeweilige Verdampferschiffchen erwünschte aus dem Stand der Technik bekannte optimale Mischung zu kommen, ist es in der Regel notwendig, das Material mit zusätzlichem $TiB_2$ und/oder BN und/oder AlN-Pulver abzumischen.

Die nach den beschriebenen Verfahren erhaltenen Pulver können auch anteilig den üblichen Standardpulvermischungen für Verdampferschiffchen zugegeben werden.

Die Pulver lassen sich in allen Fällen beispielsweise durch Heißpressen oder Heißisostatpressen wieder zu Verdampferschiffchen verarbeiten.

Verdampferschiffchen, die wiederaufgearbeitete Pulver enthalten, zeigen im Betrieb gegenüber bekannten Verdampferschiffchen überraschenderweise Vorteile bei der Anwendung, insbesondere bei der Kontrolle des Verdampfungsprozesses. Aufgrund des alterungsbedingten Widerstandsabfalls beim Betrieb von Verdampferschiffchen ist generell ein Nachregeln der Leistung, mit der die Verdampfer erhitzt werden, erforderlich, um ein gleichmäßiges Abdampfen des Metalls zu gewährleisten. Überraschenderweise zeigte sich nun, daß die Materialalterung während des Einsatzes zurückgeht, wenn Schiffchen wiederaufgearbeitetes, bereits einmal gesintertes Material enthalten. Es kommt dadurch bereits bei einem Anteil von 50 Gew.% an wiederaufgearbeitetem Material zu einer merklichen Verlangsamung des Widerstandsabfalls. Dies ermöglicht eine genauere Nachregulierung der Verdampferleistung und damit eine bessere Kontrolle des Verdampfungsprozesses.

Die folgenden Beispiele dienen der weiteren Erläuterung der Erfindung:

**Beispiel 1**

Zwei Chargen gebrauchter Verdampferschiffchen wurden jeweils getrennt, wie im folgenden beschrieben, aufgearbeitet. Charge 1 bestand aus Verdampferschiffchen aus $AlN/TiB_2/BN$. Charge 2 bestand aus Verdampferschiffchen aus $TiB_2/BN$. Die Charge wurde mit einem Backenbrecher zerkleinert. Der Grobanteil wurde mittels eines 1000 μm Siebes abgetrennt und zur weiteren Zerkleinerung in den Backenbrecher zurückgeführt. Der Feinanteil wurde in einer Strahlmühle weiter zerkleinert. Nach Abschluß der Mahlung in der Strahlmühle bei einer Korngröße unter 100 μm wurde das Pulver in einem Würfelmischer 2 Stunden homogenisiert.

Diese Ausgangsmischung wurde in Keramiktiegeln in sauerstofffreier Stickstoff-Atmosphäre mit 0,05-0,1 MPa (1/2 bis 1 bar) Druck und 1000°C 24 Stunden geglüht.

Die Analyse ergab für beide Chargen einen Restgehalt von 0.09 % freiem Aluminium.

Die Behandlung führte zu Chargen folgender Zusammensetzung (in Gew.%):

| (Charge I) | (Charge II) |
|---|---|
| 22,5 % AlN | 3,5 % AlN |
| 28 % BN | 47,5 % BN |
| 49,5 % $TiB_2$ | 49 % $TiB_2$ |

**Beispiel 2**

Das nach Beispiel 1 (Charge I) hergestellte Recyclingpulver der Zusammensetzung (in Gew.-%) 49,5 % $TiB_2$; 28 % BN; 22,5 % AlN wurde folgendermaßen auf die Standardzusammensetzung 50 % $TiB_2$; 30 % BN; 20 % AlN abgemischt:

Zur Herstellung von 20 kg Verdampferrohstoff wurden 17,5 kg recycletes Material mit 1,35 kg $TiB_2$-Pulver und 1,15 kg BN-Pulver versetzt und in einem Kunststoffaß mit Stahlkugeln auf dem Rollenbock 1 h gemischt. Nach dem konventionellen Heißpreßverfahren in Graphitformen wurde das Pulver bei 1950°C und einem spez. Druck von 8,0 MPa verdichtet. Der fertige Verdampferkörper von 180 mm Durchmesser und 200 mm Höhe wies eine Dichte von 96,1 ± 0,3 % der theoretischen Dichte auf.

Aus dem Block wurde ein Verdampferschiffchen der Abmessung 110 mm x 20 mm x 10 mm herausgeschnitten und mit einer Vertiefung von 70 mm x 15 mm x 2 mm versehen. Der spezifische elektrische Wider-

EP 0 543 398 B1

stand des Verdampferschiffchens lag bei 920 $\mu\Omega$cm. Im Heißtest beim Verdampfen von Aluminium zeigte das Verdampferschiffchen das gleiche Benetzungsverhalten und die gleiche Lebensdauer wie ein entsprechendes Verdampferschiffchen aus neuen Rohstoffen. Der Widerstandsabfall des erfindungsgemäßen Verdampfers im Heißtest war jedoch um ca. 30 % geringer als der von Verdampferschiffchen aus neuen Rohstoffen.

**Beispiel 3**

Das nach Beispiel 1 (Charge I) hergestellte Recyclingpulver wurde zu 15,0 Gew.-% einer Mischung aus neuem Pulver zugegeben, wobei die Einwaagen so abgestimmt wurden, daß die im Beispiel 2 aufgezeigte Standardmischung resultierte.
Mischung und Heißpressen wurden wie im Beispiel 2 durchgeführt. Die Dichte des fertigen Körpers betrug 96,4 $\pm$ 0,3 %. Das entsprechend Beispiel 2 herausgearbeitete Schiffchen hatte einen spezifischen elektrischen Widerstand von 960 $\mu\Omega$cm. Im Heißtest zeigte sich kein Unterschied zu einem entsprechenden Verdampferschiffchen aus neuem Material.

**Beispiel 4**

Das nach Beispiel 1 (Charge II) hergestellte Recyclingpulver der Zusammensetzung (in Gew.%) 49 % $TiB_2$; 47,5 % BN; 3,5 % AlN wurde auf die Standardzusammensetzung 50 % $TiB_2$; 30 % BN; 20 % AlN abgemischt. Für einen 20 kg Ansatz wurden 12,6 kg recycletes Material mit 3,8 kg $TiB_2$-Pulver und 3,6 kg AlN-Pulver versetzt und, wie im Beispiel 2 erläutert, auf dem Rollenbock gemischt und heißgepreßt. Die Dichte des fertigen Körpers betrug 96,2 $\pm$ 0,3 %. Das entsprechend Beispiel 2 herausgearbeitete Schiffchen hatte einen spezifischen elektrischen Widerstand von 930 $\mu\Omega$cm. Der Widerstandsabfall im Heißtest war gegenüber einem Verdampferschiffchen aus neuen Rohstoffen ca. 10 % geringer; sonst zeigten sich keine Unterschiede.

**Patentansprüche**

1. Verfahren zum Wiederaufarbeiten von keramischen Verdampferschiffchen, dadurch gekennzeichnet, daß gebrauchte, mit Aluminium verunreinigte keramische Verdampferschiffchen zerkleinert und in stickstoffhaltiger Atmosphäre geglüht werden.

2. Verfahren nach Anspruch 1, dadurch gekennzeichnet, daß die gebrauchten Verdampferschiffchen Titanborid und Bornitrid enthalten.

3. Verfahren nach Anspruch 1 oder 2, dadurch gekennzeichnet, daß die Verdampferschiffchen auf Korngößen unter 1000 $\mu$m zerkleinert werden.

4. Verfahren nach einem der Ansprüche 1 bis 3, dadurch gekennzeichnet, daß als stickstoffhaltige Atmosphäre $NH_3$ oder $N_2$ verwendet wird.

5. Verfahren nach einem der Ansprüche 1 bis 4, dadurch gekennzeichnet, daß bei einer Temperatur zwischen 400 und 1000°C über einen Zeitraum bis zu 100 Stunden geglüht wird.

6. Verfahren nach einem der Ansprüche 1 bis 5, dadurch gekennzeichnet, daß vor dem Glühen Kohlenstoff in feinverteilter Form bis zu 10 Gew.% zugesetzt wird.

7. Verdampferschiffchen, hergestellt unter Verwendung einer Pulvermischung, hergestellt nach einem Verfahren gemäß einem der Ansprüche 1 bis 6.

8. Verdampferschiffchen, dadurch gekennzeichnet, daß gebrauchte, mit Aluminium verunreinigte Verdampferschiffchen zerkleinert werden, die erhaltenen Pulver in $N_2$-haltiger Atmosphäre geglüht werden und die erhaltenen Pulver in bekannter Weise zu Verdampferschiffchen verarbeitet werden.

**Claims**

1. Method for reprocessing ceramic evaporator boats, characterized in that used, aluminium-contaminated ceramic evaporator boats are comminuted and roasted in a nitrogen-containing atmosphere.

4

2. Method according to Claim 1, characterized in that the used evaporator boats contain titanium boride and boron nitride.

3. Method according to Claim 1 or 2, characterized in that the evaporator boats are comminuted to particle sizes of less than 1000 μm.

4. Method according to any of Claims 1 to 3, characterized in that the nitrogen-containing atmosphere used is $NH_3$ or $N_2$.

5. Method according to any of Claims 1 to 4, characterized in that roasting is carried out at a temperature of between 400 and 1000°C over a time of up to 100 hours.

6. Method according to any of Claims 1 to 5, characterized in that up to 10 % by weight of carbon in finely dispersed form is added before roasting.

7. Evaporator boat produced using a powder mixture prepared by a method according to any of Claims 1 to 6.

8. Evaporator boat, characterized in that used, aluminium-contaminated evaporator boats are comminuted, the powders obtained are roasted in an $N_2$-containing atmosphere and the powders obtained are methoded in a known manner to produce evaporator boats.

**Revendications**

1. Procédé de retraitement de nacelles d'évaporation en matière céramique, procédé caractérisé en ce que l'on broie les nacelles usagées contaminées par de l'aluminium puis on calcine la poudre obtenue en atmosphère azotée.

2. Procédé selon la revendication 1, caractérisé en ce que les nacelles usagées contiennent du borure de titane et du nitrure de bore.

3. Procédé selon la revendication 1 ou 2, caractérisé en ce que l'on broie les nacelles en grains de moins de 1000 μm.

4. Procédé selon l'une des revendications 1 à 3, caractérisé en ce que l'atmosphère azotée est constituée d'ammoniac ou d'azote.

5. Procédé selon l'une des revendications 1 à 4, caractérisé en ce que l'on effectue la calcination entre 400 et 1000 °C en une durée pouvant aller jusqu'à 100 heures.

6. Procédé selon l'une des revendications 1 à 5, caractérisé en ce que, avant de calciner la matière, on lui ajoute du carbone finement divisé dans une proportion pouvant s'élever jusqu'à 10 % en poids.

7. Nacelles d'évaporation fabriquées avec un mélange pulvérulent obtenu par un procédé selon l'une des revendications 1 à 6.

8. Nacelles d'évaporation caractérisées en ce qu'elles sont obtenues par broyage de nacelles usagées contaminées par de l'aluminium, calcination de la poudre formée en atmosphère azotée puis traitement de la poudre de manière connue pour en former de nouvelles nacelles d'évaporation.